# EUROPÄISCHE PATENTANMELDUNG

(11) **EP 0 707 217 A2**
(43) Veröffentlichungstag der Anmeldung: **17.04.1996**
(21) Anmeldenummer: 95115674.4
(22) Anmeldetag: 05.10.1995
(51) Int. Cl.: G01R 21/133

(54) **Batteriegespeister Verbrauchszähler mit umschaltender Messcharakteristik**

(30) Priorität: 15.10.1994 DE 4437014
(71) Anmelder: SPANNER-POLLUX GmbH, D-67063 Ludwigshafen (DE)
(72) Erfinder: Blumbach, Rainer, Dr. Ing., D-67122 Altrip (DE)
(74) Vertreter: Patentanwälte Dipl.-Ing. F.W. Möll Dipl.-Ing. H.Ch. Bitterich

(57) **Zusammenfassung**

Gegenstand der Erfindung ist eine Schaltungsanordnung für batteriegespeiste elektronische Verbrauchszähler, mit deren Hilfe bei Unter- bzw. Überschreiten eines Schwellwertes (S) die Meßcharakteristik umgeschaltet werden kann. Diese Schaltungsanordnung besteht aus einer Widerstandsbrücke mit Meßwiderstand (2), Referenzwiderstand (3) und zwei Brückenwiderständen (4, 5). In Serie zur Widerstandsbrücke (2, 3, 4, 5) liegt ein Kondensator (6). Die an der Widerstandsbrücke (2, 3, 4, 5) abzugreifenden Meß- und Referenzspannungen (U12, U13) sind über Schwellwertschalter (7, 8) auf den D-Eingang (14) bzw. den Takteingang (15) eines D-Flipflops (9) geschaltet. Eine Steuerlogik (10) schaltet einen Umschalter (1) so, daß zu Beginn einer Meßperiode ein Meßstrom und ein Referenzstom fließen und am Ende einer Messung das D-Flipflop (9) zurückgesetzt wird. Am Ausgang (11) des D-Flipflops (9) erscheint ein Signal, wenn der Schwellwert (S) überschritten ist.

## Beschreibung

Die Erfindung betrifft batteriegespeiste elektronische Verbrauchszähler mit einer bei Unter- bzw. Überschreiten eines Schwellwertes umschaltenden Meßcharakteristik gemäß dem Oberbegriff des Anspruchs 1.

In der Meßtechnik besteht sehr oft der Wunsch, mit einer wenig Energie verbrauchenden Schaltung schnell und sicher feststellen zu können, ob eine physikalische Größe, die sich in eine elektrische Widerstandsänderung umsetzen läßt, eine bestimmte Schwelle über- oder unterschreitet. Bisher sind zwar sehr genaue Meßschaltungen bekannt geworden, mit deren Hilfe sich das gestellte Problem lösen ließe; diese sind jedoch viel zu aufwendig und verbrauchen unerwünscht viel Batteriestrom (z.B. EP-A-0 489 959).

Der vorliegenden Erfindung liegt daher die Aufgabe zugrunde, eine einfache Schaltungsanordnung der eingangs genannten Art anzugeben, die einfach und doch ausreichend genau ist und für die Messung nur eine sehr kurze Zeit benötigt, wodurch auch nur ein außerordentlich geringer Stromverbrauch erfolgt.

Diese Aufgabe wird gelöst durch einen elektronischen Verbrauchszähler mit den Merkmalen des Anspruchs 1.

Neben dem einfachen Aufbau liegt der Vorteil der vorliegenden Erfindung darin, daß die Schwelle als ein eindeutiges digitales Signal vorliegt und daß sich die Schaltungsanordnung leicht als Halbleiterschaltung integrieren läßt.

Vorteilhafte Weiterbildungen sind Gegenstand der Unteransprüche, auf die hiermit Bezug genommen wird.

Die Erfindung, ihre Weiterbildungen und ihre Vorteile sollen anhand des Ausführungsbeispiels in der Zeichnung dargestellt werden. Darin zeigen
- Fig. 1: ein Schaltbild einer Schwellwert-Erkennungsschaltung für einen batteriegespeisten Verbrauchszähler,
- Fig. 2: die Spannungsverläufe in der Schaltung der Fig. 1 an vier ausgewählten Punkten bei unterschrittener Schwelle und
- Fig. 3: die Spannungsverläufe in der Schaltung der Fig. 1 an denselben ausgewählten Punkten bei überschrittener Schwelle.

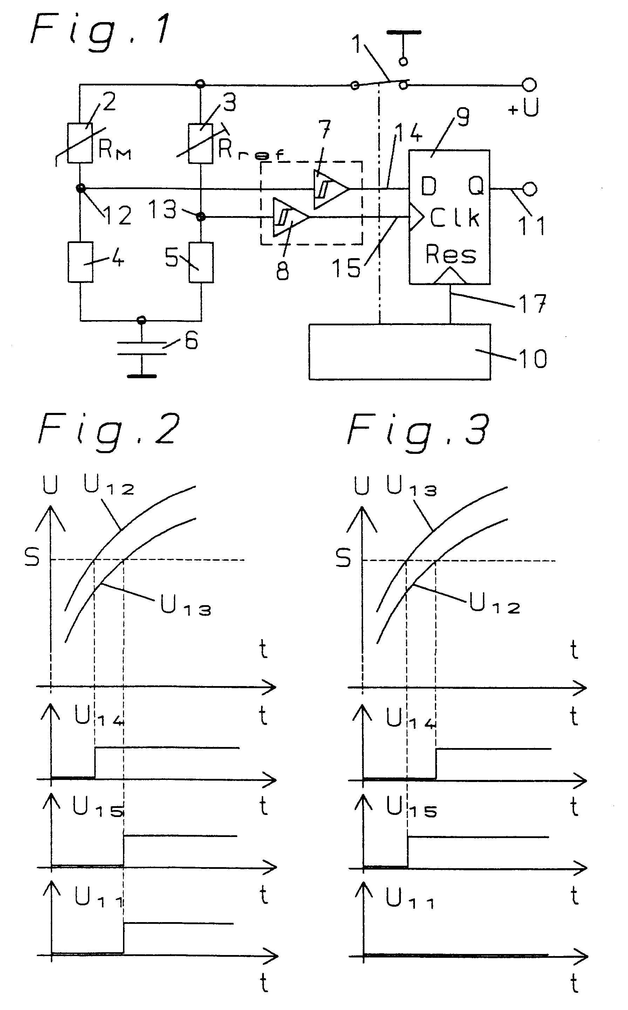

Fig. 1 zeigt eine Schaltungsanordnung mit einer Widerstandsbrücke, bestehend aus einem Meßwiderstand 2, einem Referenzwiderstand 3 und zwei weiteren Widerständen 4, 5. Alle vier Widerstände 2, 3, 4, 5 sollten in etwa denselben Widerstandswert haben. Zwischen Widerstandsbrücke 2, 3, 4, 5 und Masse liegt ein Kondensator 6.

Die beiden Brückenwiderstände 4, 5 lassen sich auch als Potentiometer realisieren, dessen Abgriff am Kondensator 6 liegt.

Alternativ lassen sich die beiden Brückenwiderstände 4, 5 auch als Kondensatoren ausführen. Der weitere Kondensator 6 entfällt dann.

Zwischen Widerstandsbrücke 2, 3, 4, 5 und Versorgungsspannungsquelle +U befindet sich ein Umschalter 1, dessen einer Schaltkontakt mit der Versorgungsspannungsquelle +U und dessen anderer Schaltkontakt mit Masse verbunden ist.

Von der Widerstandsbrücke 2, 3, 4, 5 wird am Punkt 12 eine Meßspannung abgegriffen, an einen Schmitt-Trigger 7 und von diesem über eine Leitung 14 an den D-Eingang eines D-Flipflops 9 geführt. Eine Referenzspannung wird an einem Punkt 13 abgegriffen, an einen weiteren Schmitt-Trigger 8 und von diesem über eine Leitung 15 an den Takteingang CLK des D-Flipflops 9 geführt.

Schließlich ist noch eine Steuerlogik 10 vorgesehen, die zu Beginn eines Meßvorgangs den Umschalter 1 so betätigt, daß ein Meßstrom und ein Referenzstrom fließen, und am Ende eines Meßvorgangs über die Leitung 17 das D-Flipflop 9 in seinen Ausgangszustand zurücksetzt.

Am Ausgang Q des D-Flipflops 9 erscheint ein logisches Signal, welches Auskunft darüber gibt, ob die vom Meßwiderstand 2 gemessene physikalische Größe die am Referenzwiderstand 3 eingestellte Schwelle überschritten hat oder nicht. Dieses digitale Signal kann über eine Leitung 11 einem umschaltbaren Meßwerk (nicht dargestellt) des elektronischen Verbrauchszählers zugeführt werden.

Fig. 2 zeigt die Spannungsverläufe an verschiedenen ausgewählten Punkten der Schaltung in Fig. 1.

Im obersten Diagramm sind ausschnittsweise dargestellt die Verläufe der Meßspannung U12 und der Referenzspannung U13. Beide folgen einer e-Funktion aufgrund des in Serie zur Widerstandsbrücke 2, 3, 4, 5 geschalteten Kondensators 6, jedoch mit unterschiedlicher Steigung.

Die beiden nächstfolgenden Diagramme zeigen die Spannungsverläufe U14 und U15 am Ausgang der Schmitt-Trigger 7, 8. Sobald eine eingestellte Spannungsschwelle S überschritten wird, wechseln die Spannungen U14, U15 von logisch Null auf logisch Eins. Sind die Schmitt-Trigger 7, 8 - auch andere Schwellwertschalter sind ohne weiteres verwendbar - monolithisch integriert, haben etwaige Änderungen der Versorgungsspannung +U und/oder der Umgebungstemperatur keinen Einfluß auf die Genauigkeit der Schaltungsanordnung.

Das letzte Diagramm zeigt schließlich den Spannungsverlauf U11 am Ausgang Q des D-Flipflops 9. Da aufgrund der Widerstandsverhältnisse von Meßwiderstand 2 und Referenzwiderstand 3 die Spannung U14 am D-Eingang des D-Flipflops 9 bereits auf logisch Eins war, bevor die Spannung U15 am Takteingang CLK des D-Flipflops 9 auf logisch Eins ging, springt die Spannung U11 am Ausgang Q des D-Flipflops 9 ebenfalls auf logisch Eins. Dies bedeutet, daß bei einem Meßwiderstand 2 mit negativer Charakteristik die Schwelle S überschritten war, bei einem Meßwiderstand mit positiver Widerstandscharakteristik dagegen, daß die Schwelle noch nicht überschritten war.

Fig. 3 zeigt die Spannungsverläufe an denselben Punkten der Schaltungsanordnung nach Fig. 1, wenn die Meßspannung U12 langsamer ansteigt als die Referenzspannung U13. In diesem Fall springt die Spannung U15 am Takteingang CLK des D-Flipflops 9 früher auf logisch Eins als die Spannung am D-Eingang, worauf die Spannung U11 am Q-Ausgang des D-Flipflops 9 auf logisch Null bleibt.

Die in den Fig. 2 und 3 dargestellten Spannungsverläufe stellen sich dann ein, wenn die Serienschaltung aus Widerstandsbrücke 2, 3, 4, 5 und Kondensator 6 zu Beginn einer Meßperiode mit Hilfe des Umschalters 1 an die Plus-Versorgungsspannung +U gelegt wird. Am Ende der Meßperiode legt der Umschalter 1 die Widerstands-Kondensator-Kombination dann an Masse, so daß der Kondensator 6 wieder entladen wird, und setzt das D-Flipflop 9 wieder zurück. Es versteht sich, daß der Umschalter 1 auch umgekehrt angesteuert werden kann, so daß der Kondensator 6 normalerweise auf die Versorgungsspannung +U aufgeladen ist und der Kondensator-Entladestrom die Meß- und Referenzspannungen erzeugt.

Zur Justierung des Schwellwerts S können der Referenzwiderstand 3 oder einer der anderen Brückenwiderstände 4, 5 justierbar oder die Brückenwiderstände 4, 5 als Potentiometer mit dem Abgriff am Kondensator 6 ausgebildet werden. Auf diese Weise lassen sich auch etwaige Unsymmetrien in der Schaltung, beispielsweise hervorgerufen durch unterschiedliche Schaltpegel in den Schwellwertschaltern 7, 8 und/oder durch Schaltverzögerungen des D-Flipflops 9, bedingt durch die sogenannte Set-up-Zeit am D-Eingang, ausgleichen.

## Patentansprüche

1. Batteriegespeister elektronischer Verbrauchszähler mit einer bei Unter- bzw. überschreiten eines Schwellwertes (S) umschaltenden Meßcharakteristik, umfassend einen Meßwiderstand (2) und einen Referenzwiderstand (3), Schwellwertschalter (7, 8) für Meß- und Referenzspannung (U₁₂, U₁₃) sowie wenigstens ein umschaltbares Meßwerk, gekennzeichnet durch die Merkmale:
- Meß- und Referenzwiderstand (2, 3) bilden mit weiteren Widerständen (4, 5) eine Widerstandsbrücke,
- in Serie zur Widerstandsbrücke (2, 3, 4, 5) liegt ein Kondensator (6),
- Meß- und Referenzspannung (U₁₂, U₁₃) sind über die Schwellwertschalter (7, 8) auf den D-Eingang (14) bzw. den Takteingang (15) eines D-Flipflops (9) geschaltet,
- in Serie zur Widerstandsbrücke (2, 3, 4, 5) liegt ein Schalter (1),
- es ist eine Steuerlogik (10) vorgesehen,
-- die während einer Messung den Schalter (1) so schaltet, daß ein Meßstrom und ein Referenzstrom fließen,
-- und die am Ende einer Messung das D-Flipflop (9) zurücksetzt.

2. Verbrauchszähler nach Anspruch 1, gekennzeichnet durch die Merkmale:
- der Schalter (1) ist ein Umschalter,
- der eine Schaltkontakt ist mit der Spannungsquelle (+U), der andere mit Masse und die Schaltzunge mit der Widerstandsbrücke (2, 3, 4, 5) verbunden.

3. Verbrauchszähler nach Anspruch 1 oder 2, gekennzeichnet durch das Merkmal:
- die Schwellwertschalter (7, 8) sind monolithisch integrierte Schmitt-Trigger.

4. Verbrauchszähler nach Anspruch 1, 2 oder 3, gekennzeichnet durch das Merkmal:
- der Referenzwiderstand (3) ist einstellbar.

5. Verbrauchszähler nach Anspruch 1, 2 oder 3, gekennzeichnet durch das Merkmal:
- wenigstens einer der Brückenwiderstände (4, 5) ist einstellbar.

6. Verbrauchszähler nach einem der Ansprüche 1 bis 4, gekennzeichnet durch das Merkmal:
- anstelle der Brückenwiderstände (4, 5) sind Kondensatoren vorgesehen.

7. Verbrauchszähler nach einem der Ansprüche 1 bis 6, gekennzeichnet durch die Merkmale:
- der Meßwiderstand (2) ist temperaturabhängig,
- der Verbrauchszähler ist ein temperaturbewertender Warmwasserzähler.
